# EUROPEAN PATENT SPECIFICATION

(11) **EP 0 730 277 B1**
(45) Date of publication and mention of the grant of the patent: **13.11.2002**
(21) Application number: 95830064.2
(22) Date of filing: 28.02.1995
(51) Int. Cl.: G11C 16/00, H01L 27/115, H01L 21/8247

(54) **EEPROM memory cells matrix with double polisilicon level and relating manufacturing process**
EEPROM-Speicherzellenmatrix mit doppelter Polysiliziumebene und Herstellungsverfahren
Matrice de cellules de mémoire EEPROM à double niveau de polysilicium et procédé de fabrication associé

(43) Date of publication of application: 04.09.1996
(73) Proprietor: STMicroelectronics S.r.l., 20041 Agrate Brianza (Milano) (IT)
(72) Inventor: Pio, Federico, I-20154 Milano (IT); Paruzzi, Paola, I-20059 Robbiate (CO) (IT)
(74) Representative: Botti, Mario

(56) References cited:
- EP-A- 0 255 159
- US-A- 4 766 088
- US-A- 5 326 999
- PATENT ABSTRACTS OF JAPAN vol. 16 no. 521 (E-1285) ,27 October 1992 & JP-A-04 196175 (FUJITSU LTD)
- PATENT ABSTRACTS OF JAPAN vol. 13 no. 459 (E-832) ,17 October 1989 & JP-A-01 179369 (TOSHIBA CORP)

## Description

### Field of the Invention

This invention relates to an EEPROM memory cells matrix with double polysilicon level and related manufacturing process.

In particular, the invention concerns a cells matrix in MOS technology, wherein the cells are arranged into rows and columns and integrated monolithically on a substrate of semiconductor material. Each cell comprises, placed in series with each other, a transistor of the floating gate type, having two superposed layers of polysilicon which are separated by an intervening layer of a dielectric material, and a selection transistor having a gate which comprises a first polysilicon layer. The gates of the selection transistors in one row of the matrix are connected electrically together by a selection line which comprises a second polysilicon layer overlying the first layer. Reference will be made in this description to such an application of the invention.

The invention also relates to a process for manufacturing with MOS technology a matrix of memory cells of the above type.

### Prior Art

As well known, non-volatile memories of the EEPROM type allow the information contained in the cell matrix to be modified electrically at the programming stage, both during the write and the erase steps thereof.

In addition, the information contained in each individual cell can be modified independently of the other cells. This feature ensues from the provision, in each cell, of a selection transistor placed in series with the element whereinto the information is stored. The selection transistor enables a given row to be selected either for programming or reading the individual cell.

As known, for memories of the non-volatile type, the cells are integrated on a substrate of semiconductor material, usually monocrystalline silicon, and arranged into rows and columns to form the cell matrix. The information-storing element of the cell is a MOS transistor of the floating gate type. The logic state or level, of the cell is determined by the amount of charge contained in the floating gate of the transistor. Non-volatile memories of standard types are programmed in two logic states, a written and an erased one, for storing one bit per cell. Especially with EEPROMs, the charge amount is altered by having charges passed, by tunnel effect, through a thin layer of silicon oxide, the so-called tunnel oxide which is interposed between the substrate of semiconductor material and the floating gate of the transistor, in an active region.

In the floating gate transistors of EEPROM cells, of the type known as FLOTOX, the floating gate also extends laterally beyond the tunnel oxide region.

There are EEPROMs of two basic types: a first type which is provided with a single level of polysilicon, namely polycrystalline silicon -- briefly, "poly" -- and a second type with two levels of polysilicon, to which the present invention is specifically related. The current trend of the relevant art is discussed, for instance, in H. E. Meas et al. "Trends in semiconductor memories", Microelectronics Journal, Vol. 10, 1989. Although its manifacture involves a relatively more complicated process, this second type of memory cells, having reduced overall circuit area requirements by a factor of 1.5 to 2.5, affords increased information storage density for a given area.

The selection transistor associated with each cell also is, according to the prior art, fabricated with MOS technology, and includes a polysilicon gate which is coupled electrically to the substrate by means of a thin oxide layer, called the gate oxide, which is formed directly on the substrate in an active region thereof. This gate substantially is formed of a polysilicon layer which at the formation stage corresponds, according to the prior art, to one of the polysilicon layers of the floating gate transistor. In accordance with another, more recent technique, the gates of the selection transistors include a first layer of polysilicon and are connected electrically, along the same row in the matrix, by a selection line which comprises a second layer of polysilicon overlying the first. The two layers are shorted together throughout the selection line to form a thicker single layer. The last-mentioned case has been discussed, for example, in European Patent Applications No.s 93830061.3 (EP-A-612 107) and 93830062.1 (EP-A-612 108) filed on February 19, 1993 by this Applicant.

To lower the space requirements, and hence the production cost, of such cells, the current trend favors a cell structure which can be made by a process allowing of reduced misalignment tolerances. Thus, in the specific instance of EEPROM cells having double polysilicon level, a so-called self-aligned process is often used, wherein the two polysilicon layers of the floating gate transistor, and possibly of the selection transistor as well, are patterned simultaneously using a photolithography technique.

This prior process consists, as relates to the case discussed in the above Patent Applications, of:
defining along the rows a first layer of polysilicon, or polyl, for the floating gate,
depositing subsequently a layer of intermediate dielectric,
removing the dielectric layer from the region occupied by the selection lines,
depositing a second layer of polysilicon, or poly2,
and self-alignedly removing the polyl/dielectric/poly2 stack to pattern the floating gate and control gate of the transistor, as well as the gate of the selection transistor.

Such a process may pose problems from the inherent misalignment of different masks successively employed during the cell formation, basically the masks used to remove the intermediate dielectric and the stack. Dependent on the shapes of the masks. that is on whether the masks used for removing the interpoly dielectric and the whole poly2/interpoly/poly1 stack overlap each other or not, a pit in the silicon substrate may be dug all over the region of the active area encompassed by the aperture in the mask used to remove the interpoly dielectric; or conversely, a polysilicon buildup may occur between the selection transistor and the floating gate transistor.

A known EEPROM memory device having an integrated structure overcoming some of the above inconveniences is disclosed in US Patent No. 5,326,999. In the latter the selection line constituted of the second polysilicon layer is partly insulated from the first polysilicon of the selection gates by the same interpoly dielectric interposed between floating gate and control gate in the memory cells. The electrical continuity between the two layers is ensured by contacts formed inside the select line. The two polysilicon layers are in electrical contact through the first metallization layer. Even if the self aligned process can be used, the process for forming the contact in the select line is quite complex, requiring a dedicated mask.

The underlying technical problem of this invention is to provide a matrix of EEPROM cells, in particular a structure of a selection transistor, which can be formed by a process wherein neither are pits dug into the substrate nor polysilicon buildups allowed over the substrate in regions within the cell matrix. Concurrently therewith, the matrix of memory cells to which this invention is directed should be simple to make.

The problem is also one of providing a cells matrix which can be fabricated by process steps which make for a limited introduction of tolerances, while ensuring the full operability of the device even where misalignments occur between successive masks.

A particular object is to provide a cell which has reduced integration area requirements.

### Summary of the Invention

In accordance with this invention, a matrix of EEPROM cells with double polysilicon level, being arranged into rows and columns and monolithically integrated on a substrate of a semiconductor material, usually of monocrystalline silicon, is of the type wherein each cell comprises a floating gate MOS transistor in series with a selection MOS transistor. The floating gate transistor allows the information to be stored, and includes a floating gate and overlying control gate which are both formed of polysilicon and are separated by a layer of a dielectric material. The selection transistor includes a gate of polysilicon having a first layer of polysilicon; the gates of selection transistors in one row are connected electrically together by a selection line which includes a second layer of polysilicon overlying the first layer.

According to this invention, partially formed between the first and second layers in the selection line is an intermediate layer of a dielectric material. The two layers of polysilicon are in direct contact with each other in at least one zone of the selection line.

In a preferred embodiment, the above-mentioned zone is formed over field oxide regions, periodically within the matrix or beyond it.

Based on the solutive idea on which this invention stands, the technical problem is solved by a matrix of EEPROM cells as indicated above and defined in the characterizing portion of Claim 1.

The technical problem is also solved by a process for manufacturing with MOS technology a matrix of EEPROM cells having two levels of polysilicon, as defined in the characterizing portion of Claim 7.

The features and advantages of a matrix of EEPROM cells according to the invention will be apparent from the description of an embodiment thereof, given by way of example and not of limitation with reference to the accompanying drawings.

### Brief Description of the Drawings

In the drawings:
Figure 1 is a top view showing schematically a first embodiment of an EEPROM cell according to this invention;
Figures 2-7 are top views of the same cell, separately bringing out the structures and layers of its topography;
Figure 8 is a vertical section view taken along line A-A in Figure 1;
Figure 9 is a sectional view taken along line B-B through the floating gate transistor;
Figure 10 is a vertical section view of the selection transistor, as taken along line C-C; and
Figure 11 is a top view of a portion of a cells matrix, according to a second embodiment of this invention.

### Detailed Description

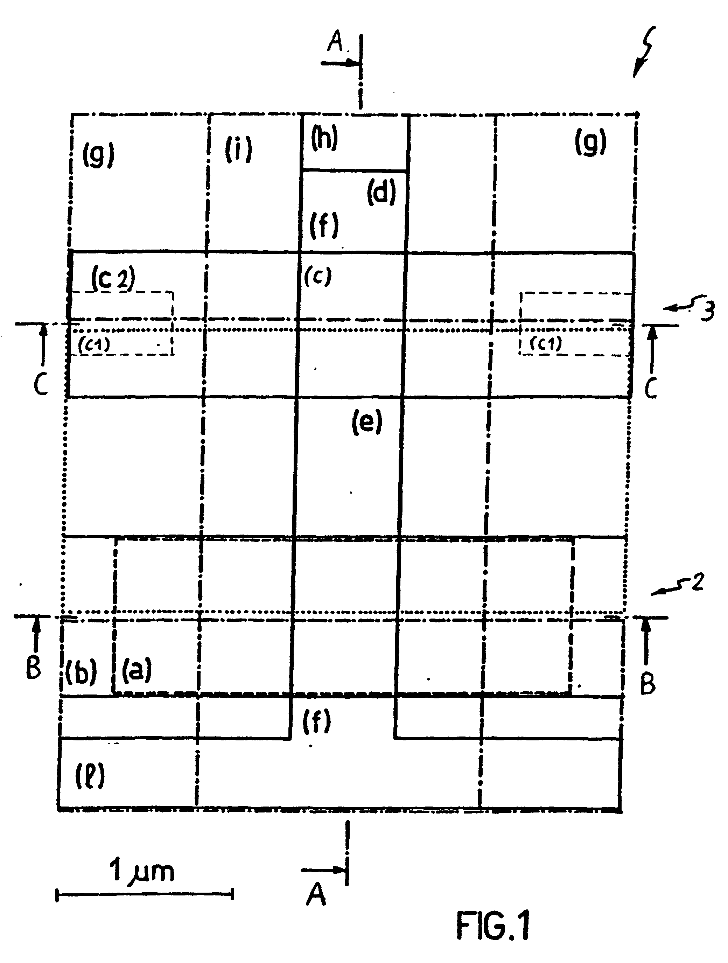

A description of a first embodiment of a matrix of EEPROM memory cells having double polysilicon level, according to the invention, will be given herein below with initial reference to a preferred scheme of a single cell, shown in Figure 1. The cell is depicted as a top view and is denoted by the reference numeral 1. The cell shown would be repeated a large number of times to provide a matrix wherein identical or symmetrical cells are arranged into rows and columns. The dimensions relate illustratively to a cell of 0.8-micron technology having a capacitive coupling of 0.7 between the control gate and the floating gate.

The EEPROM memory cell of this invention has two levels of polysilicon. Its basic construction is consistent with that of conventional cells of the ETOX type as used in FLASH-EPROMs. Each cell 1 comprises a floating gate MOS transistor, denoted by 2, having a selection MOS transistor, denoted by 3, formed in series therewith.

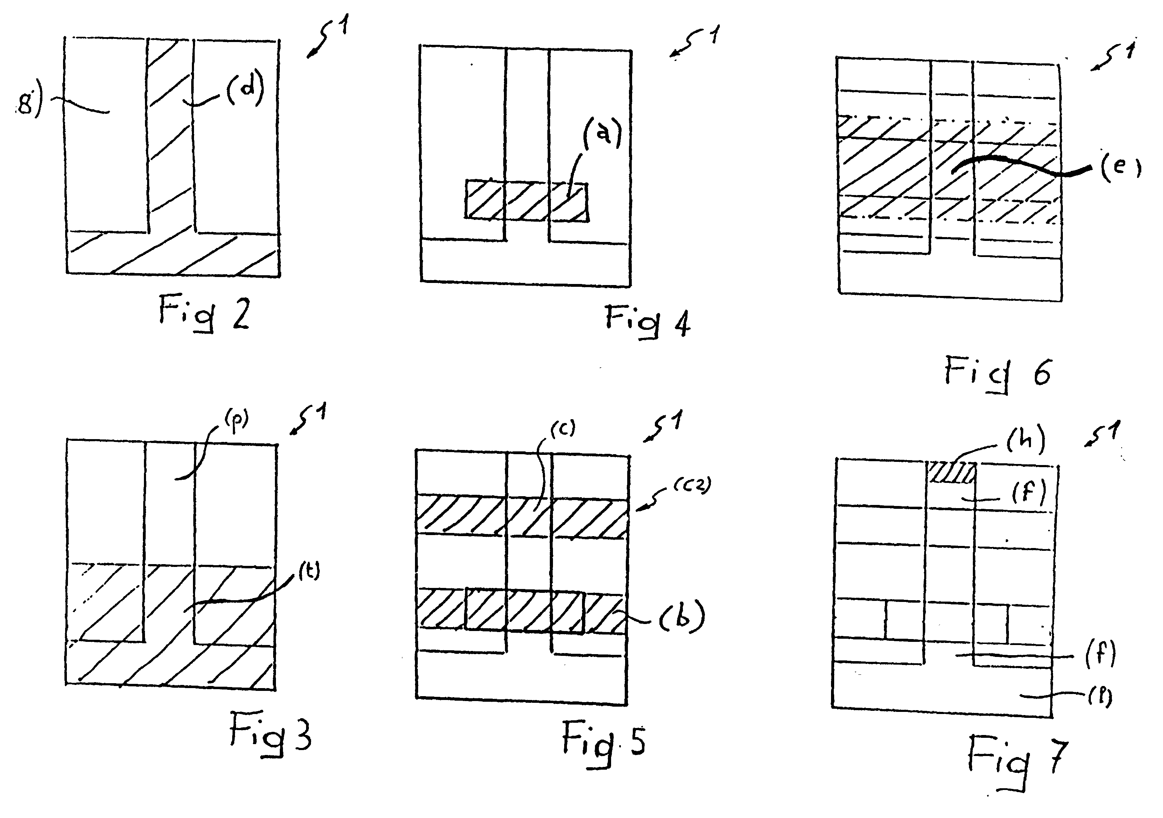

The structures and layers of the cell topography are shown separately and successively in Figures 2-7, for clarity. The cell 1 structure is formed on a substrate of a semiconductor material, usually of a monocrystalline silicon material.

With reference to Figures 1 and 2, shown at (d) are the active area regions, being complementary of the so-called field oxide (g) regions wherein a thick oxide layer is formed over the substrate.

Formed over the substrate in the active area region, at the transistor 2, is a thin region of so-called tunnel oxide (t), shown in Figure 3. A thin gate oxide (p), which may be a different thickness, is correspondingly formed in the active area region of the selection transistor 3.

The floating gate of the transistor 2, including a first polysilicon layer, is represented by region (a) in Figures 1 and 4. It functions to store information, i.e. some charge which enables the two states of written and erased to be identified.

Formed on top of the floating gate is a control gate of that transistor 2 which comprises a second layer of polysilicon and is denoted by (b) in Figures 1 and 5. The control gate further comprises, in accordance with a preferential prior technique, an overlying layer of silicide, better shown in cross-section in later Figures. The control gate (b) is capacitively coupled to the floating gate (a) through an intermediate dielectric layer, referred to hereinafter as the interpoly dielectric. The control gate (b) electrode is common to all the cells in one row or sector of the matrix.

Figures 1 and 5 also show a gate region (c) of the selection transistor 3 which overlies an active area region. The gate (c) comprises the first layer of polysilicon in one embodiment of this invention. The gates of the selection transistors in one row are connected electrically together by a selection line which is represented by region (c2) in the portion occupied by the cell 1. The selection line (c2) includes the aforementioned second layer of polysilicon, overlying the first and being partially isolated therefrom by a layer of interpoly dielectric.

In the region shown at (e) in Figures 1 and 6, between the respective gates of the transistors 1 and 2, namely between regions (b) and (c), there may be provided, in accordance with a prior art technique, a double implant of arsenic and phosphorus for the purpose of reducing the so-called band-to-band current. This is a phenomenon discussed, for example, in L. Ravazzi et al. "Comparison degradation effects in abrupt and graded N+-P gated junctions due to band-to-band tunnel current", ESREF 1990, October 2-5. 1990, Bari, IT.

Shown at (f) in Figures 1 and 7 are source and drain doped regions of the cell, where an implant is performed, typically arsenic. Furthermore, (h) is a drain contact, in common with cell 1 and a cell, not shown in the Figures, which is formed on top of the cell 1 and has a symmetrical structure therewith. The source regions in one row or sector of cells are interconnected by line (1) in common, within the matrix, with the cell 1 and an underlying cell symmetrical therewith. The source line may be of the SAS (Self-Aligned Source) type. The reference (i), only appearing in Figure 1, identifies a metallic interconnect line between the drain contacts of cells belonging to the same column in the memory matrix.

According to this invention, the first and second polysilicon layers of the selection transistor 3 in the regions (c1) shown in Figure 1 are in direct contact. The intermediate layer is removed from between the two layers of polysilicon in the regions (c1) but is left there through the remainder of the selection line (c2), and in particular over the gate regions (c). Such regions (c1) advantageously locate, in a preferred embodiment and as shown in the Figure, in zones where the selection line spans field oxide (g) regions.

The contact regions (c1) lie, as shown in Figure 1, within the selection line (c2) and away from the edges of the latter, in a preferred embodiment of the invention, as discussed hereinafter in connection with a manufacturing process therefor.

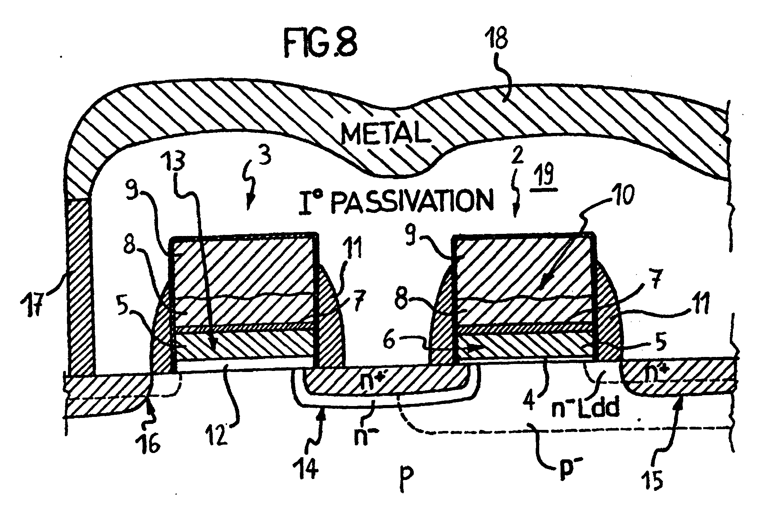

Figures 8, 9 and 10 are vertical section views, not to scale, of the cell 1, taken along parallel directions to the rows and the columns.

Specifically, Figure 8 is a sectional view taken along a line A-A drawn in Figure 1 through the active area region of the floating gate transistor 2 and the selection transistor 3, along the source-to-drain direction. The floating gate transistor 2 includes a thin layer of tunnel oxide 4, formed directly on the substrate, which is successively overlaid by the first polysilicon layer 5 forming the floating gate 6, the interpoly dielectric 7, and the second polysilicon layer 8, the latter being in turn overlaid, in accordance with a prior art technique, by a silicide layer 9. The control gate of the transistor 2 is denoted by 10. Formed laterally of the the gates of the transistor 2 are so-called spacer oxide layers 11. The selection transistor 3 is similarly formed. The thin gate oxide is denoted by 12 and the gate, including the first polysilicon layer 5, denoted by 13. As can be seen, no differences stand out in cross-section along this direction between the floating gate transistor 2 and the selection transistor 3, but for the different thickness of the tunnel oxide 4 from that of the gate oxide 12.

Also shown schematically in Figure 8 are implanted regions 14, which correspond to the regions (e) in Figure 6, and the source and drain regions, 15 and 16. A drain contact 17 is conventionally connected to a metallization line 18 which is separated by a passivation layer 19 from the transistors 2 and 3 of the cell 1.

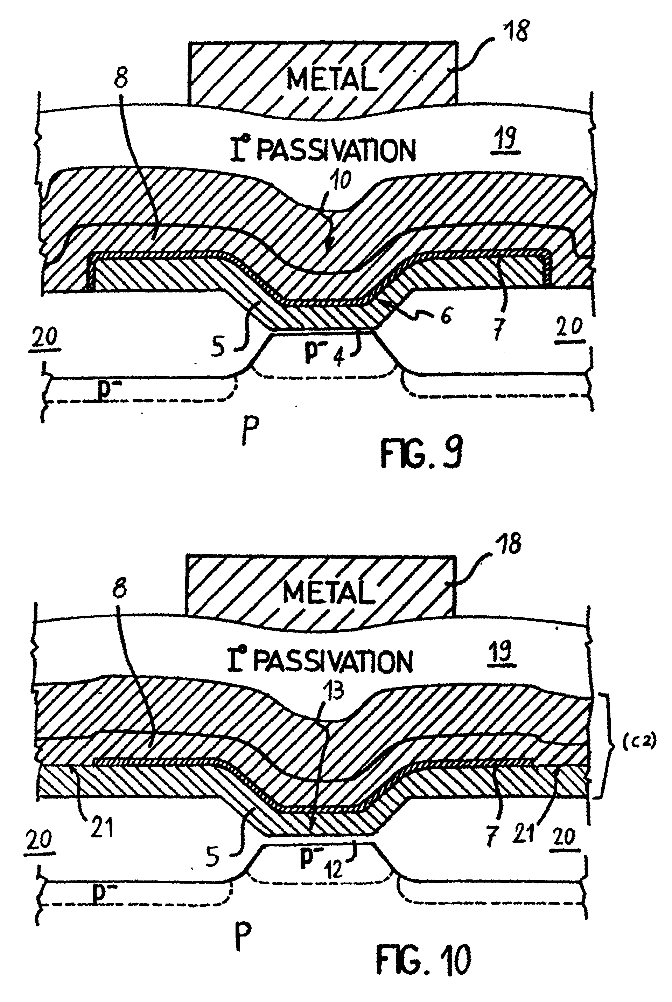

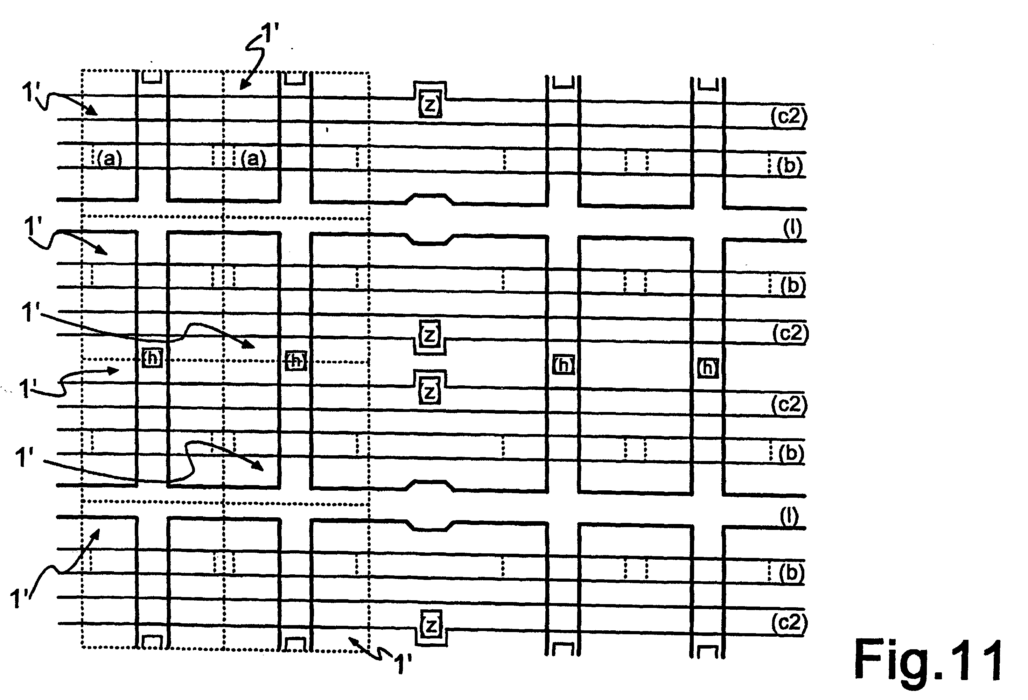

Figures 9 and 10 are respective sectional views of the floating gate transistor 2 and the selection transistor 3, taken along lines B-B and C-C in Figure 1, perpendicularly to the source-to-drain direction. In these Figures, a layer of field oxide 20, not shown in Figure 8, extends laterally of the central active area region. The first polysilicon layer 5 of the floating gate 6 of the transistor 2 and of the gate 13 of the selection transistor 3 extends partly thereacross.

From a comparison of these two Figures, the difference can be clearly noticed which exists between the floating gate transistor 2 and the selection transistor 3. In the floating gate transistor 2, the first polysilicon layer 5, i.e. the floating gate 6, is fully isolated by means of the interpoly dielectric 7. In the selection transistor 3, the first polysilicon layer 5, included in the gate 13, is instead in contact with the second polysilicon layer 8 of the selection line, in the regions 21 that correspond to the regions (c1) in Figure 1.

In accordance with this invention, the first polysilicon layer 5 of the selection transistor 3 and the overlying second polysilicon layer 8 are in electric contact with each other. Therefore, the gates of the selection transistors in one row or sector will be connected electrically together and to the selection line, which is applied a voltage for selecting the row or sector. In this way, the operability of the inventive cell can be ensured, by providing electric continuity between the two layers of polysilicon at a low access resistance to the gates of selection transistors.

The contact between the two layers of polysilicon is, as brought out by the embodiment just described, conveniently effected on field oxide. This prevents, as more fully explained hereinafter, problems with the cell formation, and especially in forming the selection transistor.

In accordance with the invention, the contact zone between the two polysilicon layers need not be provided at each cell, and can be repeated periodically every N cells. For example, a contact zone may be formed for each byte, each pair of bytes, or each source line. Increased distance from one contact to the next results in higher series resistance, as seen from the farthest cell from that contact.

Where the matrix is discontinued periodically, such as in order to accommodate so-called voltage switches, the two layers of polysilicon in the selection line can be shorted in these zones. Furthermore, the contact zone could still lie within the selection line.

Shown in Figure 11 is a second embodiment of the invention wherein the two layers of polysilicon are in contact along the selection line at each byte. This Figure shows a top view of a portion of a matrix of memory cells, with each cell being designated 1' and constructed in accordance with the invention. Indicated at (z) are those zones of the selection line where the first and second polysilicon layers contact each other. The regions (z) are advantageously formed within pads, i.e. within enlarged areas of the selection line. These areas enable contact regions (z) to be formed with sufficient breadth, while limiting any problems from misalignment during their formation.

Where the spacing between any two adjacent selection lines is insufficient to accommodate a pair of corresponding pads, one pad may be formed every two bytes, alternately on the two lines.

The process steps for manufacturing a matrix of EEPROM cells according to the invention will now be described in detail with reference to the previous Figures.

Preferably, a self-aligned process is used to form the cell matrix of this invention. Reference will be made, therefore, specifically to a process of this type.

The forming process comprises the following steps:
forming the active area regions and isolation regions, i.e. the field oxide 20;
growing by thermal oxidation a thin oxide, namely the tunnel oxide 4 and gate oxide 12, in the active area regions, to possibly different thicknesses, respectively in those zones where the floating gate transistor 2 and the selection transistor 3 are to be formed;
forming, usually by deposition, a first polysilicon layer 5 over the whole matrix;
patterning, using a photolithographic masking technique followed by etching, the first polysilicon layer 5 in the zones occupied by the floating gate transistor 2 along a parallel direction to the source-to-drain lines, thereby to define the floating gates 6 in that direction; in practice, the polysilicon layer would only be removed from the regions included between two contiguous floating gates in one row;
growing or depositing an interpoly dielectric layer 7 all over the matrix;
removing that interpoly dielectric layer 7, in accordance with the invention, from just regions 21 lying within the selection lines (c2) and away from their edges at locations where the two polysilicon layers 5 and 8 are to contact each other;
forming the second polysilicon layer 8, optionally followed by a silicide layer 9, all over the cells matrix; and
photolithographically defining and then etching away the poly2/interpoly/poly1 stack in a perpendicular direction to the source-to-drain direction to fully pattern in a self-aligned fashion the control gate 10 and floating gate 6 of the floating gate transistor 2, as well as the selection line (c2).

The process is completed with well-known steps of implantation, formation of the oxide spacers 11, deposition of the passivation layer 19, and formation of contact openings and metallization layers 18.

In accordance with this invention, as previously described, the mask used to etch away the poly2/interpoly/poly1 stack will completely cover the openings in the mask used to etch away the intermediate dielectric layer. This is ensured by the contact zones between the two layers of polysilicon in the selection line being fully contained therein because away from its edges.

Thus, the proposed solution avoids the problem of the undesired formation of steps in the substrate or, conversely, of polysilicon buildups in the region between the floating gate transistor and the selection transistor.

It should be noted that during the precise patterning of the topography it will be necessary to take account of inherent misalignments during the masking step. For example, in manufacturing a matrix of memory cells of the type to which this invention relates, the maximum admissible misalignment would typically be about 0.3 microns using 0.8-micron technology. Accordingly, it is recommended that the contact zones between the first and second layers of polysilicon in the selection line be kept a sufficient distance away from the selection line edges to include such tolerances.

To this aim, as shown for instance in Figure 11, pads would advantageously be formed, of preference, in the selection line to accommodate the contact zones.

Also, in the above embodiments of the invention, the contact zones are formed over field oxide regions not to damage active area regions in the event of excess misalignment occurring, for example.

Thus, the memory matrix of this invention allows a fabrication process to be used which provides the selection transistor while limiting the introduction of necessary tolerances during successive process steps, yet ensuring the device operability.

The process, moreover, may advantageously be a self-aligned one enabling the space requirements for the cells matrix to be reduced.

A matrix according to the invention involves no complications to its manufacturing process, either in terms of mask number or additional processing steps, compared to conventional processes for manufacturing a cells matrix.

It should be understood that changes and modifications may be made unto the matrix of memory cells herein described and illustrated, within the scope of the invention as defined in the following claims.

## Claims

1. A matrix of EEPROM memory cells with a double polysilicon level, in MOS technology, being arranged into rows and columns, monolithically integrated on a substrate of a semiconductor material in a matrix area, and each memory cell comprising a transistor (2) of the floating gate type including two superposed layers of polysilicon (5 and 8) which are separated by an interpoly layer (7) of a dielectric material, and a selection transistor (3) in series with said floating gate transistor (2) which has a gate (13) comprising a first layer of polysilicon (5); the gates (13) of the selection transistors (3) in one row of said matrix being connected electrically together by a selection line (c2) which comprises a second layer of polysilicon (8) overlying the first layer (5), and being partly insulated therefrom by said interpoly layer (7), **characterized in that** said interpoly layer (7) is so patterned that said first and second polysilicon layers(5 and 8) are in direct contact in at least one zone (21) of said selection line (c2) within said matrix area.

2. A cells matrix according to Claim 1, **characterized in that** said zone (21) where the first and second layers of polysilicon (5 and 8) are in contact lies outside the gates (13) of the selection transistors (3) over regions where a layer of field oxide (20) has been formed on the substrate.

3. A cells matrix according to Claim 2, **characterized in that** said zone (21) is formed in equidistant regions within the cell matrix.

4. A cells matrix according to Claim 1, **characterized in that** the first and second layers of polysilicon (5 and 8) are in contact in a zone (z) of the selection line (c2) located outside a cell .

5. A cells matrix according to Claim 1, **characterized in that** said contact zone (21) between said first and second layers of polysilicon (5 and 8) lies within said selection line (c2), away from its edges.

6. A cells matrix according to Claim 5, **characterized in that** said contact zone (21) locates within enlarged areas of said selection line (c2).

7. A process for manufacturing with MOS technology a matrix of EEPROM memory cells having double polysilicon level arranged into rows and columns and being of the type wherein, for each cell within a matrix area, there are formed in series, on a substrate of semiconductor material, a floating gate transistor (2) including first and second layers of polysilicon (5 and 8) superposed on each other and separated from each other by an interpoly layer (7) of a dielectric material, and a selection transistor (3) having a gate (13) which comprises the first layer of polysilicon (5), and wherein the gates (13) of the selection transistors (3) in one row are connected electrically together by a selection line (c2) which comprises the second layer of polysilicon (8) and is formed over the first layer of polysilicon (5), **characterized in that**, prior to forming the second layer of polysilicon (8), said intermediate layer of dielectric material (7) is formed in said selection line (c2) and removed from at least one zone (21) of the selection line within the matrix area, so that said first and second polysilicon layers (5 and 8) are in direct contact in at least one zone (21) of said selection line (c2).

8. A process according to Claim 7, **characterized in that**, for removing the interpoly dielectric layer (7) from said zone (21) of the selection line (c2), a mask is used which is opened within the selection line, away from the edges thereof.

9. A process according to Claim 7, **characterized in that** said zone (21) is formed outside the gates (13) of the selection transistors (3), over regions where a layer of field oxide (20) has been previously formed.

10. A process according to Claim 7, **characterized in that** the first and second layers of polysilicon (5 and 8) are formed at the floating gate transistors (2) and the selection transistors (3) of the matrix, by a self-aligned process.

11. An integrated EEPROM memory circuit of MOS technology, **characterized in that** it comprises a matrix of cells, arranged into rows and columns, constructed as claimed in Claim 1.

## Patentansprüche

1. Matrix von EEPROM-Speicherzellen mit einer doppelten Polysiliziumebene in MOS-Technologie, die in Reihen und Spalten angeordnet und monolithisch auf einem Substrat eines Halbleitermaterials in einem Matrixbereich integriert sind, und wobei jede Speicherzelle einen Transistor (2) der Schwebegate-Bauart, der zwei übereinanderliegende Schichten aus Polysilizium (5 und 8) aufweist, die durch eine Zwischenschicht (7) eines dielektrischen Materials getrennt sind, und einen Auswahltransistor (3) in Reihe mit dem Schwebegatetransistor (2) umfasst, der ein Gate (13) aufweist, das eine erste Schicht aus Polysilizium (5) umfasst; wobei die Gates (13) der Auswahltransistoren (3) in einer Matrixreihe elektrisch miteinander über eine Auswahlleitung (c2) verbunden sind, die eine zweite Schicht aus Polysilizium (8) umfasst, die die erste Schicht (5) überlagert und teilweise durch die Zwischenschicht (7) davon abisoliert ist, **dadurch gekennzeichnet, dass** die Zwischenschicht (7) so gestaltet ist, dass die erste und zweite Polysiliziumschicht (5 und 8) sich miteinander in mindestens einer Zone (21) der Auswahlleitung (c2) innerhalb des Matrixbereichs in direktem Kontakt befinden.

2. Zellenmatrix nach Anspruch 1, **dadurch gekennzeichnet, dass** die Zone (21), in der sich die erste und zweite Schicht aus Polysilizium (5 und 8) miteinander in Kontakt befinden, außerhalb der Gates (13) der Auswahltransistoren (3) über Bereichen liegen, in denen auf dem Substrat eine Schicht aus Feldoxids (20) gebildet wurde.

3. Zellenmatrix nach Anspruch 2, **dadurch gekennzeichnet, dass** die Zone (21) in Bereichen mit gleichem Abstand innerhalb der Zellenmatrix gebildet ist.

4. Zellenmatrix nach Anspruch 1, **dadurch gekennzeichnet, dass** sich die erste und zweite Schicht aus Polysilizium (5 und 8) in einer Zone (z) der Auswahlleitung (c2), die außerhalb einer Zelle angeordnet ist, in Kontakt befinden.

5. Zellenmatrix nach Anspruch 1, **dadurch gekennzeichnet, dass** die Kontaktzone (21) zwischen der ersten und zweiten Schicht aus Polysilizium (5 und 8) innerhalb der Auswahlleitung (c2) fern von ihren Rändern liegt.

6. Zellenmatrix nach Anspruch 5, **dadurch gekennzeichnet, dass** die Kontaktzone (21) in erweiterten Bereichen der Auswahlleitung (c2) angeordnet ist.

7. Verfahren zum Herstellen einer Matrix von EEPROM-Speicherzellen mit doppelter Polysiliziumebene mittels MOS-Technologie, die in Reihen und Spalten angeordnet sind und von der Bauart sind, bei der für jede Zelle in einem Matrixbereich in Reihe auf einem Substrat eines Halbleitermaterials ein Schwebegatetransistor (2), der eine erste und zweite Schicht aus Polysilizium (5 und 8) aufweist, die übereinander gelagert sind und voneinander über eine Zwischenschicht (7) aus einem dielektrischen Material getrennt sind, und ein Auswahltransistor (3) gebildet sind, der ein Gate (13) aufweist, das die erste Schicht aus Polysilizium (5) umfasst, und wobei die Gates (13) der Auswahltransistoren (3) in einer Reihe elektrisch miteinander über eine Auswahlleitung (c2) verbunden sind, die die zweite Schicht aus Polysilizium (8) umfasst und über der ersten Schicht aus Polysilizium (5) gebildet ist, **dadurch gekennzeichnet, dass** vor dem Bilden der zweiten Schicht aus Polysilizium (8) die Zwischenschicht aus dielektrischem Material (7) in der Auswahlleitung (c2) gebildet wird und aus der mindestens einen Zone (21) der Auswahlleitung im Matrixbereich entfernt wird, so dass die erste und zweite Polysiliziumschicht (5 und 8) sich in der mindestens einen Zone (21) der Auswahlleitung (c2) in direktem Kontakt befinden.

8. Verfahren nach Anspruch 7, **dadurch gekennzeichnet, dass** zum Entfernen der dielektrische Zwischenschicht (7) aus der Zone (21) der Auswahlleitung (c2) eine Maske verwendet wird, die in der Auswahlleitung geöffnet wird, und zwar fern von den Rändern derselben.

9. Verfahren nach Anspruch 7, **dadurch gekennzeichnet, dass** die Zone (21) außerhalb der Gates (13) der Auswahltransistoren (3) über Bereichen gebildet wird, in denen zuvor eine Schicht aus Feldoxid (20) ausgebildet wurde.

10. Verfahren nach Anspruch 7, **dadurch gekennzeichnet, dass** die erste und zweite Schicht aus Polysilizium (5 und 8) an den Schwebegatetransistoren (2) gebildet werden und die Auswahltransistoren (3) der Matrix durch ein selbstausgerichtetes Verfahren gebildet werden.

11. Integrierte EEPROM-Speicherschaltung der MOS-Technologie, **dadurch gekennzeichnet, dass** sie eine Matrix von Zellen umfasst, die in Reihen und Spalten angeordnet und wie in Anspruch 1 aufgebaut sind.

## Revendications

1. Matrice de cellules de mémoire EEPROM présentant deux niveaux de polysilicium, suivant la technologie MOS, agencée de manière à former des lignes et des colonnes, intégrée de manière monolithique sur un substrat d'un matériau semi-conducteur dans une région de la matrice, et chaque cellule de mémoire comprenant un transistor (2) du type à grille flottante comprenant deux couches superposées de polysilicium (5 et 8) séparées par une couche interpoly (7) constituée d'un matériau diélectrique, et un transistor de sélection (3) placé en série avec ledit transistor à grille flottante (2) qui présente une grille (13) comprenant une première couche de polysilicium (5) ; les grilles (13) des transistors de sélection (3) d'une ligne de ladite matrice étant connectées ensemble par une ligne de sélection (c2) qui comprend une deuxième couche de polysilicium (8) recouvrant la première couche (5), et étant en partie isolée par ladite couche interpoly (7), **caractérisée en ce que** ladite couche interpoly (7) est configurée de telle sorte que lesdites première et deuxième couches de polysilicium (5 et 8) sont en contact direct dans au moins une zone (21) de ladite ligne de sélection (c2) à l'intérieur de ladite région de la matrice.

2. Matrice de cellules selon la revendication 1, **caractérisée en ce que** ladite zone (21) dans laquelle les première et deuxième couches de polysilicium (5 et 8) sont en contact se trouve à l'extérieur des grilles (13) des transistors de sélection (3) sur des régions où une couche d'oxyde épais (20) a été formée sur le substrat.

3. Matrice de cellules selon la revendication 2, **caractérisée en ce que** ladite zone (21) est formée dans des régions équidistantes à l'intérieur de la matrice de cellules.

4. Matrice de cellules selon la revendication 1, **caractérisée en ce que** les première et deuxième couches de polysilicium (5 et 8) sont en contact dans une zone (z) de la ligne de sélection (c2) située à l'extérieur d'une cellule.

5. Matrice de cellules selon la revendication 1, **caractérisée en ce que** ladite zone de contact (21) entre lesdites première et deuxième couches de polysilicium (5 et 8) se trouve à l'intérieur de ladite ligne de sélection (c2), à distance de ses bords.

6. Matrice de cellules selon la revendication 5, **caractérisée en ce que** ladite zone de contact (21) se trouve à l'intérieur de régions élargies de ladite ligne de sélection (c2).

7. Procédé destiné à fabriquer, en utilisant une technologie MOS, une matrice de cellules de mémoire EEPROM présentant deux niveaux de polysilicium, agencées de manière à former des lignes et des colonnes et étant du type selon lequel, pour chaque cellule se trouvant à l'intérieur d'une région de la matrice, sont placées en série, sur un substrat de semi-conducteur, un transistor à grille flottante (2) comprenant des première et deuxième couches de polysilicium (5 et 8) superposées et séparées l'une de l'autre par une couche interpoly (7) de matériau diélectrique, et un transistor de sélection (3) présentant une grille (13) qui comprend la première couche de polysilicium (5), et dans lequel les grilles (13) des transistors de sélection (3) d'une ligne sont connectées par une ligne de sélection (c2) qui comprend la deuxième couche de polysilicium (8) et qui est formée sur la première couche de polysilicium (5), **caractérisé en ce que**, avant de réaliser la deuxième couche de polysilicium (8), ladite couche intermédiaire du matériau diélectrique (7) est formée dans ladite ligne de sélection (c2) et retirée d'au moins une zone (21) de la ligne de sélection à l'intérieur de la région de matrice, de telle sorte que lesdites première et deuxième couches de polysilicium (5 et 8) sont en contact direct dans au moins une zone (21) de ladite ligne de sélection (c2).

8. Procédé selon la revendication 7, **caractérisé en ce que**, pour retirer la couche diélectrique interpoly (7) de ladite zone (21) de la ligne de sélection (c2), on utilise un masque qui est ouvert à l'intérieur de la ligne de sélection, à distance de ses bords.

9. Procédé selon la revendication 7, **caractérisé en ce que** ladite zone (21) est formée à l'extérieur des grilles (13) des transistors de sélection (3), sur des régions où une couche d'oxyde épais (20) a été formée au préalable.

10. Procédé selon la revendication 7, **caractérisé en ce que** les première et deuxième couches de polysilicium (5 et 8) sont formées au niveau des transistors à grille flottante (2) et des transistors de sélection (3) de la matrice, par un processus d'auto-alignement.

11. Circuit de mémoire EEPROM intégré réalisé selon la technologie MOS, **caractérisé en ce qu'**il comprend une matrice de cellules, agencées de manière à former des lignes et des colonnes, construit selon la revendication 1.
